(19) 

Europäisches
Patentamt
European
Patent Office
Office européen
des brevets

(11)     **EP 1 879 203 A1**

(12)                                **EUROPEAN PATENT APPLICATION**

(43) Date of publication:
**16.01.2008 Bulletin 2008/03**

(51) Int Cl.:
*H01G 9/20* (2006.01)          *H01L 51/00* (2006.01)

(21) Application number: **07110207.3**

(22) Date of filing: **13.06.2007**

(84) Designated Contracting States:
**AT BE BG CH CY CZ DE DK EE ES FI FR GB GR
HU IE IS IT LI LT LU LV MC MT NL PL PT RO SE
SI SK TR**
Designated Extension States:
**AL BA HR MK YU**

(30) Priority: **13.07.2006 KR 20060065835**

(71) Applicant: **Samsung Electronics Co., Ltd
Suwon-si, Gyeonggi-do 443-742 (KR)**

(72) Inventors:
• **Park, Young Jun,
Samsung Electronics Co., Ltd.
Yongin-si,
Gyeonggi-do 449-712 (KR)**
• **Nam, Jung Gyu,
Samsung Electronics Co., Ltd.
Yongin-si,
Gyeonggi-do 449-712 (KR)**

• **Park, Sang Cheol,
Samsung Electronics Co., Ltd.
Yongin-si,
Gyeonggi-do 449-712 (KR)**
• **Lee, Jeong Hee,
Samsung Electronics Co., Ltd.
Yongin-si,
Gyeonggi-do 449-712 (KR)**
• **Lee, Eeun Sung,
Samsung Electronics Co., Ltd.
Yongin-si,
Gyeonggi-do 449-712 (KR)**

(74) Representative: **Greene, Simon Kenneth
Elkington and Fife LLP
Prospect House
8 Pembroke Road
Sevenoaks, Kent TN13 1XR (GB)**

(54)     **Photovoltaic cell using catalyst-supporting carbon nanotube and method for producing the
same**

(57)     Disclosed herein is a photovoltaic cell using catalyst-supported carbon nanotubes and a method for producing the same. More particularly, the photovoltaic cell includes a photo anode, a cathode including a layer of metal catalyst particle supporting carbon nanotubes, and an electrolyte disposed between the photo anode and the cathode. The photovoltaic cell is economic in terms of production costs and process steps, and shows improved catalytic activity due to an enlarged contact area and conductivity, resulting in excellent photoelectric efficiency.

**EP 1 879 203 A1**

**Description**

BACKGROUND OF THE INVENTION

1. Field of the Invention

The present invention relates to a photovoltaic cell using a catalyst-supporting carbon nanotube and a method for producing the same. More particularly, the present invention relates to a photovoltaic cell which can be easily produced by a simple and economic process using a carbon nanotube containing metal catalyst particles supported thereon, and a method for producing the same.

2. Description of the Related Art

In order to overcome energy problems that have been recently confronted, various research on alternative energy sources capable of replacing the existing fossil fuel are actively underway. In particular, for the replacement of oil resources that may eventually be exhausted, many attempts have been made to develop methods for utilizing natural energy resources such as wind force, nuclear energy, solar energy, and the like.

Among these, solar (photovoltaic) cells using solar energy are of interest because solar energy is unlimited and environmentally friendly, unlike other energy sources. For example, since a dye-sensitized solar cell can be fabricated at extremely low cost, its applications have been positively considered. Specifically, the dye-sensitized solar cell has a structure that comprises a photo anode capable of generating electrons by absorbing light and delivering them; an electrolyte layer which is disposed between the photo anode and a cathode and acts as a path for carrying ions to the photo anode; and the cathode conveying the electrons returned after working via an arbitrary external circuit through an oxidation-reduction reaction at a solid/liquid interface between the electrolyte layer and the cathode. In this structure, the cathode comprises a catalytic layer formed on the surface of a substrate. The catalytic layer functions to stimulate the oxidation-reduction reaction. Accordingly, it is preferable to use raw materials and a process with a low production cost while exhibiting high catalytic activity. In prior methods, the catalytic layer of the cathode has been formed by depositing, under vacuum, a precious catalytic metal thin-film such as platinum or palladium on a transparent substrate. However, the method for preparing a catalytic metal thin-film or a catalytic metal particle requires a large quantity of catalyst and an additional procedure employing expensive and large-scale vacuum equipment for vacuum deposition, thereby increasing the cost of production. Further, such methods suffer in that the reaction surface area contacting the electrolyte layer is small, and has limited catalytic activity.

A photovoltaic device comprising a cathode having a substrate and a conductive carbon layer formed thereon has been disclosed. This device forms a catalytic layer in the cathode with conductive carbon in order to overcome the above-described problems such as the small reaction surface area, the high production cost, and the poor preparation process. However, since the cathode of such a device uses only conductive carbon as a catalyst, one drawback is that its reactivity is significantly lowered compared with a cathode using a metal particle as a catalyst.

Meanwhile, a solar cell comprising a nano-sized carbon cathode made from fibrous carbon materials has also been disclosed. However, such a solar cell has a lower conversion efficiency than that using a Pt thin-film.

BRIEF SUMMARY OF THE INVENTION

An aspect of the present invention includes providing a photovoltaic cell that can be economically fabricated in terms of the production cost and production process while exhibiting high catalytic activity.

Another aspect of the present invention includes providing a method for producing the photovoltaic cell.

In accordance with an exemplary embodiment of the present invention, a photovoltaic cell includes a photo anode, a cathode having a layer of metal catalyst particle supported carbon nanotubes, and an electrolyte disposed between the photo anode and the cathode.

The photo anode may include a transparent substrate, a transparent electrode disposed on the transparent substrate, a metal oxide layer disposed on the transparent electrode, and a dye absorbed to the metal oxide layer.

The carbon nanotubes of the layer of metal catalyst particle supported carbon nanotubes may have an average diameter of about 1 nanometer (nm) to about 100 nm, an average length of about 100 nm to about 2 micrometers ($\mu$m), a specific surface area of about 50 meters squared per gram ($m^2$/g) to about 1000 $m^2$/g, and/or a surface resistance of about 0.01 Ohms per square centimeter ($\Omega$/$cm^2$) to about 100 $\Omega$/$cm^2$. Further, carbon nanotubes having a multi-wall, a double wall or a single wall structure may be used alone or in the form of a mixture thereof.

The metal catalyst particles may be selected from the group consisting of platinum (Pt), titanium (Ti), vanadium (V), chromium (Cr), manganese (Mn), iron (Fe), cobalt (Co), nickel (Ni), copper (Cu), zinc (Zn), aluminum (Al), molybdenum (Mo), selenium (Se), tin (Sn), ruthenium (Ru), palladium (Pd), tungsten (W), iridium (Ir), osmium (Os), rhodium (Rh), niobium (Nb), tantalum (Ta), lead (Pb), bismuth (Bi), a mixture comprising at least one of the foregoing, and an alloy comprising at least one of the foregoing; and may have an average particle size of about 1 nm to about 10 nm.

In accordance with another exemplary embodiment of the present invention, a method for producing a photovoltaic cell includes preparing a cathode by coating a substrate with a solution of carbon nanotubes that support metal catalyst particles; disposing a photo anode opposite to the cathode; and disposing an electrolyte between the cathode and the photo anode.

The carbon nanotube layer may be formed by using a coating method selected from the group consisting of spin coating, spray coating, screen printing, doctor blading, ink jetting and electrophoresis.

The method may further comprise activating the carbon nanotube layer after the formation thereof.

BRIEF DESCRIPTION OF THE DRAWINGS

The above and other aspects, features and other advantages of the present invention will be more clearly understood from the following detailed description taken in conjunction with the accompanying drawings, in which:

FIG. 1 is a schematic illustration of an exemplary embodiment of a photovoltaic cell according to the present invention; and

FIG. 2 is a transmission electron microscope (TEM) image of Pt particle-supported carbon nanotubes fabricated according to an exemplary embodiment of the present invention.

DETAILED DESCRIPTION OF THE INVENTION

The present invention will now be explained more fully hereinafter with reference to the accompanying drawings, in which exemplary embodiments of the present invention are shown. This invention may, however, be embodied in many different forms and should not be construed as limited to the exemplary embodiments set forth herein. Rather, these exemplary embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present invention.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprise", "comprises", and "comprising," when used in this specification, specify the presence of stated features, integers, steps, operations, elements, components, and/or combination of the foregoing, but do not preclude the presence and/or addition of one or more other features, integers, steps, operations, elements, components, groups, and/or combination of the foregoing.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

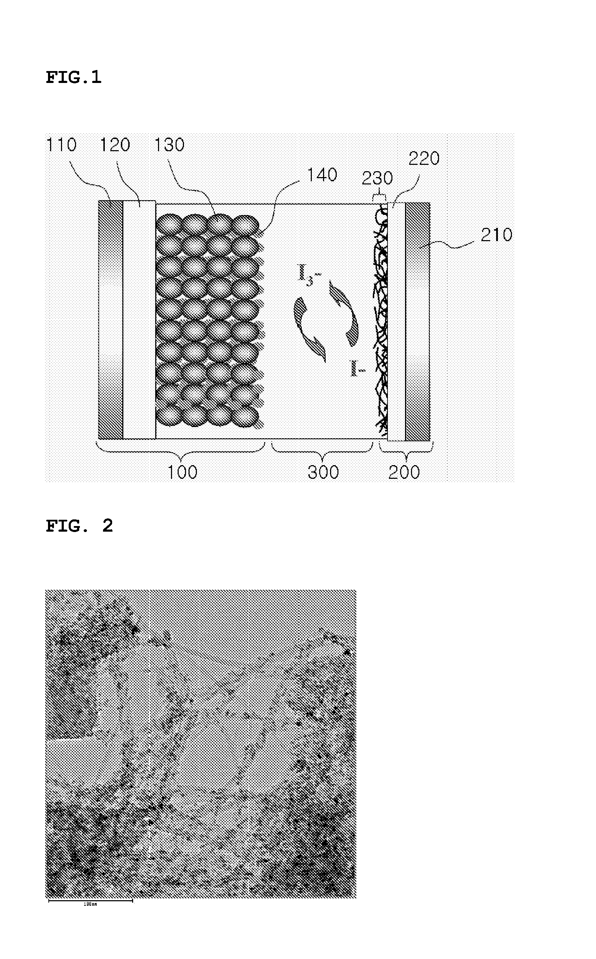

FIG. 1 illustrates an exemplary embodiment of a photovoltaic cell according to the present invention. As illustrated in FIG. 1, the dye-sensitized photovoltaic cell includes a photo anode 100, a cathode 200 comprising a metal catalyst-supported layer of carbon nanotubes 230, and an electrolyte 300.

Since currently available cathodes are manufactured by sputtering or vacuum deposition of the metal catalyst on a transparent substrate, they have several problems in that the production costs are quite high, the production process is complicated, and the reaction surface area is small resulting in low catalytic activity. In order to overcome these problems, the cathodes disclosed herein are fabricated by using metal catalyst-supported carbon nanotubes. Since the cathodes utilize a supported catalyst where nano-sized metal catalyst particles are supported on a carbon nanotube, it is possible to easily fabricate an electrode having an enlarged surface area by using only a small amount of metal through a room temperature liquid process. Further, the amount of metal catalyst particles loaded onto the carbon nanotubes can be easily controlled, which is desirable, particularly in terms of the production costs and process. In addition, due to the enlarged specific surface area and excellent conductivity of carbon nanotubes, the efficiency of a photovoltaic cell fabricated according to the present invention is excellent.

The carbon nanotubes used in the production of the cathode 200 may have an average diameter of about 1 to about 100 nanometers (nm), and specifically about 1 to about 10 nm, but is not limited thereto.

Further, there is no limitation to the length of the carbon nanotubes. In an exemplary embodiment, the carbon nanotubes have an average length of about 100 nm to about 2 micrometers ($\mu$m), and specifically about 100 nm to about 1 $\mu$m, in consideration of a specific surface area.

The carbon nanotubes may be any type of carbon nanotube, such as those having a multi-wall, a double wall, or a single wall structure, and may be in the form of a mixture thereof. Further, a specific surface area of the carbon nanotubes may be about 50 to about 1000 square meters per gram ($m^2$/g), and a surface resistance thereof may be about 0.01 to about 100 Ohms per square centimeter ($\Omega$/cm$^2$).

Examples of the metal catalyst particles that are supported on the carbon nanotubes include, but are not limited to, platinum (Pt), titanium (Ti), vanadium (V), chromium (Cr), manganese (Mn), iron (Fe), cobalt (Co), nickel (Ni), copper (Cu), zinc (Zn), aluminum (Al), molybdenum (Mo), selenium (Se), tin (Sn), ruthenium (Ru), palladium (Pd), tungsten (W), iridium (Ir), osmium (Os), rhodium (Rh), niobium (Nb), tantalum (Ta), lead (Pb), bismuth (Bi), a mixture comprising at least one of the foregoing, and an alloy comprising at least one of the foregoing. Since the metal catalyst is applied as a catalytic layer of a cathode of a solar cell, it is desirable to use platinum (Pt) or a platinum-containing alloy.

If the average particle size of the metal catalyst particles is too small, it may be difficult to initiate a catalytic reaction; however, if the average particle size is too large, the surface area of the catalyst particles decreases, thereby resulting in decreased catalytic activity. In view of the above-described considerations, the average particle size of the metal catalyst particle is desirably about 1 to about 10 nm.

The catalyst particle supported on a carbon nanotube may be prepared by a variety of methods including an infiltration method, a precipitation method, a colloid method, and the like.

In an exemplary embodiment, the amount of the metal catalyst particles is about 0.1 to 80 weight percent (wt%) based on the total weight of the carbon nanotube and supported metal catalyst particles, and can be readily tailored to the particular application by one of ordinary skill in the art. If the content of the metal catalyst particle in the supported catalyst is less than about 0.1 wt%, the efficiency of the solar cell is decreased. On the contrary, when the amount of metal catalyst particles is greater than about 80 wt%, it is economically unfavorable and the particle size thereof becomes enlarged.

The dye-sensitized photovoltaic cell of the present invention comprises a cathode 200 formed by coating a layer of metal catalyst particle-supported carbon nanotubes 230 on a conductive material 220 that is coated on the surface of a substrate 210.

Specifically, the cathode 200 may be manufactured by preparing a slurry composition or a paste composition by uniformly dispersing metal nanoparticle-supported carbon nanotubes in an organic solvent, and then coating the composition on the surface of the substrate 210 using a general room temperature liquid process.

Since the cathode comprises carbon nanotubes having nano-sized metal catalyst particles supported thereon, and is capable of being manufacturing using a room temperature liquid coating process, the costs associated with producing the cathode are low the process is simplified.

There is no particular limitation imposed on the organic solvent used. However, exemplary organic solvents include acetone, methanol, ethanol, isopropyl alcohol, n-propyl alcohol, butyl alcohol, dimethylacetamide (DMAC), dimethylformamide, dimethlysulfoxide (DMSO), N-methyl-2-pyrrolidone (NMP), tetrahydrofuran (THF), tetrabutylacetate, n-butylacetate, m-cresol, toluene, ethylene glycol (EG), $\gamma$-butyrolactone, hexafluoroisopropanol (HFIP), and the like, or a combination comprising at least one of the foregoing. The slurry or paste composition of the metal nanoparticle-supported carbon nanotubes may further comprise additives such as binder resins, viscosity regulating agents, forming agents, dispersing agents, fillers, and the like. Particular examples of these additives include glass frits, ethylene glycol, polymers or copolymers of methyl methacrylate, such as those sold under the trade name ELVACITE, polymethyl methacrylate (PMMA), and the like. Further, terpineol, dioctylphthalate, polyethylene glycol, and the like may be used as additives for regulating fluidity.

Examples of the room temperature liquid coating processes include, but are not limited to, spin coating, spray coating, screen printing, doctor blading, ink jetting, electrophoresis, and the like.

The substrate 210 may be a glass substrate or a polymeric (e.g., plastic) substrate. For improved conductivity, it is desirable to employ a transparent substrate 210 coated with a conductive material 220 such as tin-doped indium oxide (ITO), fluorine-doped tin oxide (FTO), $ZnO-Ga_2O_3$, $ZnO-Al_2O_3$, $SnO_2-Sb_2O_3$, and the like.

The cathode 200 according to the present invention has several advantages in that it can be easily produced through a process with low cost, its contact surface area with the electrolyte layer is enlarged to increase catalytic activity, and it exhibits superior conductivity. Accordingly, when the cathode is implemented in a photovoltaic cell, it is capable of improving electron delivering performance, making it possible for the photovoltaic cell to exhibit excellent photoelectric efficiency.

The photo anode 100 of the dye-sensitized photovoltaic cell may be prepared by coating a porous metal oxide on a conductive material 120 that is disposed on a transparent substrate 110 to form a metal oxide membrane 130, firing the substrate 110, and soaking the fired substrate 110 in a solution containing a dissolved dye 140 for a period of time to allow the dye 140 to be absorbed onto the surface of the metal oxide membrane 130.

The transparent substrate 110 may be the same as disclosed in the description of the cathode above.

The metal oxide 130 may be selected from the group consisting of titanium oxide, niobium oxide, hafnium oxide, tungsten oxide, tin oxide zinc oxide, and a combination comprising at least one of the foregoing, but is not limited thereto. Also, the metal oxide may be coated using a coating method such as screen printing or spin coating.

With regard to the dye 140, there is no limitation as to the material used, as long as it is photosensitive and can separate charges. Exemplary dyes 140 include ruthenium complexes, xanthine dyes such as rhodamine B, rose bengal, eosin, or erythrosine; cyanine dyes such as quinocyanine or cryptocyanine; basic dyes such as phonosafranin, Capri blue, thiocyclam, or methylene blue; porphyrin-type compounds such as chlorophyll, zinc porphyrin, or magnesium porphyrin; azo dyes; phthalocyanine compounds; complex compounds such as ruthenium trisbipyridyl; anthraquinone dyes; polycyclic quinone dyes; and the like, or combinations comprising at least one of the foregoing.

The layer of electrolyte 300 in the dye-sensitized photovoltaic cell according to the present invention includes an electrolyte that is a hole conductor. Any hole conducting electrolyte may be used. Exemplary electrolytes include, but are not limited to, an acetonitrile solution of iodine, N-methyl-2-pyrrolidone (NMP), 3-methoxypropionitrile, and the like.

There are no particular limitations as to a method for producing the overall dye-sensitized photovoltaic cell of the present invention. For example, the method may include preparing the cathode as described above; disposing a photo anode opposite to the cathode; and disposing an electrolyte between the cathode and the photo anode.

The method may further comprise activating the layer of carbon nanotubes after its formation. This activation step may be carried out by, for example, tape activation, plasma activation, or chemical etching.

Hereinafter, the present invention will be described in detail with reference to the following examples. However, it is to be understood that these examples are given for illustrative purposes only and are not to be construed as limiting the scope of the present invention.

## Examples

### Preparative Example 1: Preparation of a Pt-supported carbon nanotube

0.9422 grams (g) of $H_2PtCl_6$ were dissolved in about 20 g of ethylene glycol. Separately, about 0.25 g of single wall carbon nanotubes were dispersed in a mixture of about 100 g water and about 80 g of ethylene glycol. The carbon nanotube solution thus prepared was added to the Pt solution, and the mixture's pH was adjusted to about 11 with NaOH. After that, the mixture was allowed to stand at about 105 degrees Celsius (°C) for about 2 hours, followed by further heating at about 110 °C for about 1 hour to reduce the platinum to metallic platinum and dispose it onto the surface of the carbon nanotubes. After the reaction was complete, the reaction mixture was centrifuged to separate the Pt-supported carbon nanotubes. The Pt-supported carbon nanotubes so separated were washed with water and subjected to lyophilization or freeze-drying. Fig. 2 shows a transmission electron microscope (TEM) image of a representative sample of the Pt-supported carbon nanotubes prepared above.

### Preparative Example 2: Preparation of a cathode

About 0.55 g of the Pt-supported carbon nanotubes prepared in Preparative Example 1, about 0.5 g of glass frit, about 14 g of a binder, and about 15 g terpineol were mixed and uniformly dispersed with a 3-roll mill for about 30 minutes to prepare a paste. Then, a glass substrate coated with FTO was coated with the paste prepared above and dried at about 70 °C for about 30 minutes. Next, the glass substrate was fired at about 430 °C for about 20 minutes under a nitrogen atmosphere, and subjected to a surface treatment to prepare a cathode.

**Preparative Example 3: Preparation of a cathode**

A cathode was prepared according to the same method as described in Preparative Example 2 except for an additional step of activating the coated carbon nanotube through mechanical activation.

**Example 1: Preparation of photovoltaic cell**

After sputter coating FTO on a glass substrate, a $TiO_2$ particle paste having an average particle size of about 20 nm was coated on the glass substrate by screen printing, and was fired at about 450 °C for about 30 minutes, to thereby obtain a porous $TiO_2$ membrane having a thickness of about 15 $\mu$m. Sequentially, the glass substrate having the $TiO_2$ membrane formed thereon was soaked in a 0.3 millimolar (mM) ruthenium dithiocyanate 2, 2'-bipyridyl-4, 4'-dicarboxylate solution for about 24 hours and dried. The dye was wholly absorbed onto the surface of the $TiO_2$ layer, resulting in the photo anode.

Thereafter, the photo anode obtained above was assembled with the cathode prepared in Preparative Example 2. At this time, a polymer having a thickness of about 25 $\mu$m, which was made from SURLYN (manufactured by Du Pont), was disposed between the photo anode and the cathode. The resulting construct was placed on a heating plate of about 100 to about 120 °C, and compressed under about 1 to about 3 atmospheres of pressure. The polymer was closely adhered to the interface between the two electrodes through the heat and pressure treatment.

Then, an electrolyte was filled into the space between the two electrodes via micropores formed on the surface of the two electrodes, to thereby prepare a dye-sensitized photovoltaic cell according to the invention. The electrolyte solution used herein was a $I^{3-}/I^-$ electrolyte prepared by dissolving 0.6 molar (M) 1,2-dimethyl-3-octyl-imidazoium iodide, 0.2 M LiI, 0.04 M $I_2$, and 0.2 M 4-tert-butylpyridine(TBP) in acetonitrile.

**Example 2: Preparation of a photovoltaic cell**

A photovoltaic cell was prepared according to the same method as described in Example 1 except that the cathode prepared in Preparative Example 3 was employed.

**Comparative Example 1: Preparation of a photovoltaic cell**

A photovoltaic cell was prepared according to the same method as described in Example 1 except that a cathode, which was prepared by depositing Pt on an ITO-coated glass substrate to a thickness of about 200 nm, was employed.

**Test Example 1: Assessment of photovoltaic cell's property**

For comparing photoelectric efficiencies of the photovoltaic cells prepared in Examples 1 and 2 and Comparative Example 1, their photovoltage and photocurrent were measured. A xenon lamp (Oriel, 01193) was used as a light source, and the solar property (AM 1.5) of the xenon lamp was calibrated using a reference solar cell (Furnhofer Institute Solare Engeriessysteme, Certificate No. C-ISE369, Type of material: Mono-Si + KG filter). Photocurrent density ($I_{sc}$), open voltage ($V_{oc}$), and fill factor (FF) were determined from the photocurrent-voltage curve measured above, and photoelectric efficiency ($\eta_e$) was calculated by using the following equation:

$$\eta_e = (V_{oc} \cdot I_{sc} \cdot FF) / (P_{inc})$$

wherein $P_{inc}$ denotes 100 mW/cm$^2$(1 sun).

The results are shown in Table 1 below.

**Table 1**

| | Thickness of $TiO_2$ ($\mu$m) | $J_{sc}$(mA/cm$^2$) | $V_{oc}$(mV) | FF | h(%) |
|---|---|---|---|---|---|
| Example 1 | 17.82 | 9.896 | 649.8 | 0.746 | 4.819 |
| Example 2 | 17.85 | 10.431 | 637.7 | 0.733 | 4.893 |
| Comparative Example | 16.27 | 8.012 | 615.0 | 0.722 | 3.570 |

As can be seen from Table 1, it was found that the cathodes prepared by using the Pt-supported carbon nanotubes exhibits superior efficiency than that prepared by Pt deposition.

The present invention produces a cathode using a metal catalyst-supported carbon nanotube. Therefore, the cathode of the present invention has several advantages in that it is economic in terms of the production cost and process, and shows enlarged contact area with an electrolyte layer and superior conductivity. Thus, the cathode of the present invention can provide a dye-sensitized photovoltaic cell showing improved catalytic activity.

Although the present invention has been described with reference to the foregoing exemplary embodiments, these exemplary embodiments do not serve to limit the scope of the present invention. Accordingly, those skilled in the art to which the present invention pertains will appreciate that various modifications, additions, and substitutions are possible, without departing from the technical spirit and scope of the accompanying claims.

**Claims**

1. A photovoltaic cell, comprising:

   a photo anode 100;
   a cathode 200 comprising a layer of metal catalyst particle supported carbon nanotubes 230; and
   an electrolyte 300 disposed between the photo anode and the cathode.

2. The photovoltaic cell according to claim 1, wherein the photo anode comprises:

   a transparent substrate 110;
   a transparent electrode 120 disposed on the transparent substrate;
   a metal oxide layer 130 disposed on the transparent electrode; and
   a dye 140 absorbed to the metal oxide layer.

3. The photovoltaic cell according to claim 2, wherein the transparent substrate is a glass substrate or a polymeric substrate.

4. The photovoltaic cell according to any of claims 1 to 3, wherein the carbon nanotubes of the layer of metal catalyst particle supported carbon nanotubes have an average diameter of about 1 nanometer to about 100 nanometers.

5. The photovoltaic cell according to any of claims 1 to 4, wherein the carbon nanotubes of the layer of metal catalyst particle supported carbon nanotubes have an average length of about 100 nanometers to about 2 micrometers.

6. The photovoltaic cell according to any of claims 1 to 5, wherein the carbon nanotubes of the layer of metal catalyst particle supported carbon nanotubes are multi-wall carbon nanotubes, double wall carbon nanotubes, single wall carbon nanotubes, or a combination comprising at least one of the foregoing.

7. The photovoltaic cell according to any of claims 1 to 6, wherein the carbon nanotubes of the layer of metal catalyst particle supported carbon nanotubes have a specific surface area of about 50 square meters per gram to about square meters per gram 1000.

8. The photovoltaic cell according to any of claims 1 to 7, wherein the carbon nanotubes of the layer of metal catalyst particle supported carbon nanotubes have a surface resistance of about 0.01 Ohms per square centimeter to about 100 Ohms per square centimeter.

9. The photovoltaic cell according to any of claims 1 to 8, wherein the metal catalyst particles of the layer of metal catalyst particle supported carbon nanotubes are selected from the group consisting of platinum (Pt), titanium (Ti), vanadium (V), chromium (Cr), manganese (Mn), iron (Fe), cobalt (Co), nickel (Ni), copper (Cu), zinc (Zn), aluminum (Al), molybdenum (Mo), selenium (Se), tin (Sn), ruthenium (Ru), palladium (Pd), tungsten (W), iridium (Ir), osmium (Os), rhodium (Rh), niobium (Nb), tantalum (Ta), lead (Pb), bismuth (Bi), a combination comprising at least one of the foregoing metals, and an alloy comprising at least one of the foregoing metals.

10. The photovoltaic cell according to claim 9, wherein the metal catalyst particles of the layer of metal catalyst particle supported carbon nanotubes comprise platinum or a platinum-containing alloy.

11. The photovoltaic cell according to any of claims 1 to 10, wherein the metal catalyst particles of the layer of metal catalyst particle supported carbon nanotubes have an average particle size of about 1 nanometer to about 10 nanometers.

12. The photovoltaic cell according to any of claims 1 to 11, wherein the metal catalyst particles of the layer of metal catalyst particle supported carbon nanotubes comprise about 0.1 weight percent to about 80 weight percent of a total weight of the layer of metal catalyst particle supported carbon nanotubes.

13. The photovoltaic cell according to any of claims 1 to 12, wherein the layer of metal catalyst particle supported carbon nanotubes is formed using a coating method which is selected from the group consisting of spin coating, spray coating, screen printing, doctor blading, ink jetting, and electrophoresis.

14. A method for producing a photovoltaic cell, the method comprising:

coating a surface of a substrate 210 with a layer of metal catalyst particle supporting carbon nanotubes 230;
disposing a photo anode 100 opposite to the cathode; and
disposing an electrolyte 300 between the cathode and the photo anode.

15. The method according to claim 14, wherein forming the layer of metal catalyst particle supporting carbon nanotubes comprises a coating method which is selected from the group consisting of spin coating, spray coating, screen printing, doctor blading, ink jetting, and electrophoresis.

16. The method according to any of claims 14 to 15, further comprising activating the metal catalyst particles of the layer of metal catalyst particle supporting carbon nanotubes.

FIG.1

FIG. 2

European Patent Office

# EUROPEAN SEARCH REPORT

Application Number

EP 07 11 0207

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2006/067969 A (FUJIKURA LTD [JP]; USUI HIROKI [JP]; TANABE NOBUO [JP]; MATSUI HIROSHI) 29 June 2006 (2006-06-29) * abstract * | 1-9, 11-16 | INV. H01G9/20 H01L51/00 |
| E | -& EP 1 830 431 A (FUJIKURA LTD [JP]) 5 September 2007 (2007-09-05) * paragraphs [0046] - [0063] * ----- | 1-9, 11-16 | |
| P,X | WO 2007/064164 A (KOREA ELECTROTECHNOLOGY RES IN [KR]; LEE DONG YOON [KR]; LEE WON JAE []) 7 June 2007 (2007-06-07) * paragraphs [0029], [0032], [0039] * ----- | 1-16 | |
| A | KIM H-J ET AL: "ELECTROCHEMICAL PROPERTIES OF CARBON NANO-TUBE ELECTRODE" TRANSACTIONS OF THE KOREAN INSTITUTE OF ELECTRICAL ENGINEERS. C, vol. 54, no. 4, April 2005 (2005-04), pages 139-143, XP008055332 ISSN: 1229-246X * the whole document * ----- | | TECHNICAL FIELDS SEARCHED (IPC) H01G H01L |
| A | SUZUKI K ET AL: "APPLICATION OF CARBON NANOTUBES TO COUNTER ELECTRODES OF DYE-SENSITIZED SOLAR CELLS" CHEMISTRY LETTERS, NIPPON KAGAKUKAI, TOKYO, JP, vol. 32, no. 1, 2003, pages 28-29, XP008025168 ISSN: 0366-7022 * the whole document * ----- | | |

The present search report has been drawn up for all claims

| Place of search | Date of completion of the search | Examiner |
|---|---|---|
| The Hague | 9 October 2007 | Wolfbauer, Georg |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**ANNEX TO THE EUROPEAN SEARCH REPORT
ON EUROPEAN PATENT APPLICATION NO.**                    EP 07 11 0207

This annex lists the patent family members relating to the patent documents cited in the above-mentioned European search report.
The members are as contained in the European Patent Office EDP file on
The European Patent Office is in no way liable for these particulars which are merely given for the purpose of information.

09-10-2007

| Patent document cited in search report | | Publication date | Patent family member(s) | | Publication date |
|---|---|---|---|---|---|
| WO 2006067969 | A | 29-06-2006 | AU<br>EP<br>JP | 2005320306 A1<br>1830431 A1<br>2006202721 A | 29-06-2006<br>05-09-2007<br>03-08-2006 |
| EP 1830431 | A | 05-09-2007 | AU<br>WO<br>JP | 2005320306 A1<br>2006067969 A1<br>2006202721 A | 29-06-2006<br>29-06-2006<br>03-08-2006 |
| WO 2007064164 | A | 07-06-2007 | NONE | | |

EPO FORM P0459

For more details about this annex : see Official Journal of the European Patent Office, No. 12/82